Europäisches Patentamt

European Patent Office

Office européen des brevets

(11) Publication number: **0 551 857 A2**

# EUROPEAN PATENT APPLICATION

(21) Application number: **93100298.4**

(22) Date of filing: **11.01.93**

(51) Int. Cl.5: **H03D 7/12**

(30) Priority: **14.01.92 JP 4920/92**

(43) Date of publication of application:
**21.07.93 Bulletin 93/29**

(84) Designated Contracting States:
**DE FR GB NL SE**

(71) Applicant: **SUMITOMO ELECTRIC INDUSTRIES, LTD.**
**5-33, Kitahama 4-chome, Chuo-ku**
**Osaka-shi, Osaka 541(JP)**

(72) Inventor: **Shiga, Nobuo, c/o Yokohama Works of Sumitomo**
**Elec. Ind., Ltd., 1, Taya-cho, Sakae-ku**
**Yokohama-shi, Kanagawa(JP)**

(74) Representative: **Patentanwälte Grünecker, Kinkeldey, Stockmair & Partner**
**Maximilianstrasse 58**
**W-8000 München 22 (DE)**

(54) **Mixer circuit using pulse-doped GaAs MESFET.**

(57) A pulse-doped GaAs MESFET is employed as an active device of a mixer circuit. A gate bias point of the pulse-doped GaAs MESFET is set at the vicinity of a transition point of a transconductance-gate voltage characteristic from a portion in which the transconductance increases with the gate voltage to a portion in which the former does not vary with the latter.

FIG. 1

EP 0 551 857 A2

## BACKGROUND OF THE INVENTION

The present invention relates to a mixer circuit used in a converter (frequency conversion circuit), a measurement device, etc.

Recently, with the fast development of information network systems, the demand for satellite communication systems is rapidly increasing and higher frequency bands are going to be employed. Since a down-converter for converting a higher frequency signal to a lower frequency signal is required in the satellite communication systems, the demand for mixer circuits used in the down-converters is also increasing. Conventional mixer circuits use, as an active device, a diode, bipolar transistor, FET, etc. Generally, a usual MESFET and a HEMT are employed as the FET for such use.

The most serious problem to be addressed in designing an FET mixer circuit (i.e., a mixer circuit using the FET) is that a large-amplitude local oscillation signal causes a large variation of the FET gate voltage, which in turn causes a variation of the transconductance $g_m$ of the FET. As a result, the gate-source capacitance $C_{gs}$ and, therefore, the input impedance are varied. That is, when viewed from the RF signal input side, the FET mixer circuit operates with its input impedance being largely varied over time in accordance with the variation of the local oscillation signal. This will make it difficult to design the mixer circuit, and one cannot expect its stable operation.

## SUMMARY OF THE INVENTION

An object of the present invention is to provide a mixer circuit having a small input impedance variation.

According to the invention, a mixer circuit comprises a pulse-doped GaAs MESFET as its active device, wherein a gate bias point of the pulse-doped GaAs MESFET is set at a vicinity of a transition point of a transconductance-gate voltage characteristic from a portion in which the transconductance increases with the gate voltage to a portion in which the transconductance does not vary substantially with the gate voltage.

Recently, the pulse-doped GaAs MESFET has been proposed that has an active layer formed by a crystal growing apparatus and exhibits superior performance as a low-noise device. That is, the transconductance-gate voltage characteristic of this type of FET has a flat portion in which the transconductance does not vary with respect to the gate voltage, which characteristic cannot be obtained by usual MESFETs and HEMTs in which an active layer is formed by ion implantation. In the mixer circuit of the invention, since the gate bias point of the FET is set at the vicinity of the end of the flat portion, a large-amplitude local oscillation signal does not cause a large variation of the transconductance. As a result, the variation of the input capacitance and, therefore, the input impedance is small.

## BRIEF DESCRIPTION OF THE DRAWINGS

Fig. 1 is a block diagram showing a mixer circuit according to an embodiment of the present invention;

Fig. 2 is a sectional view showing a structure of a pulse-doped GaAs MESFET; and

Fig. 3 is a graph showing a relationship between the gate voltage $v_g$ and the transconductance $g_m$ of the pulse-doped GaAs MESFET.

## DESCRIPTION OF THE PREFERRED EMBODIMENT

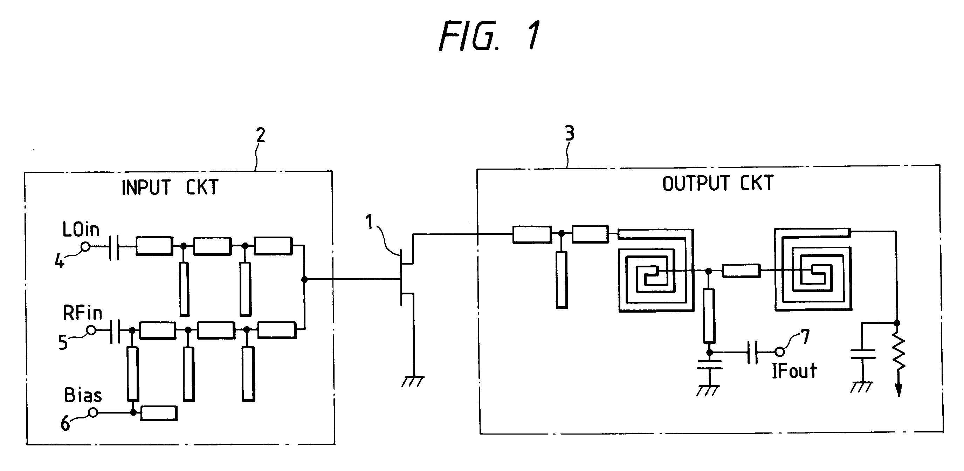

Fig. 1 is a block diagram showing a mixer circuit according to an embodiment of the present invention, which employs a pulse-doped GaAs MESFET 1 as its active device. Typical dimensions of the gate length and the gate width are 0.5 $\mu$m and 280 $\mu$m, respectively.

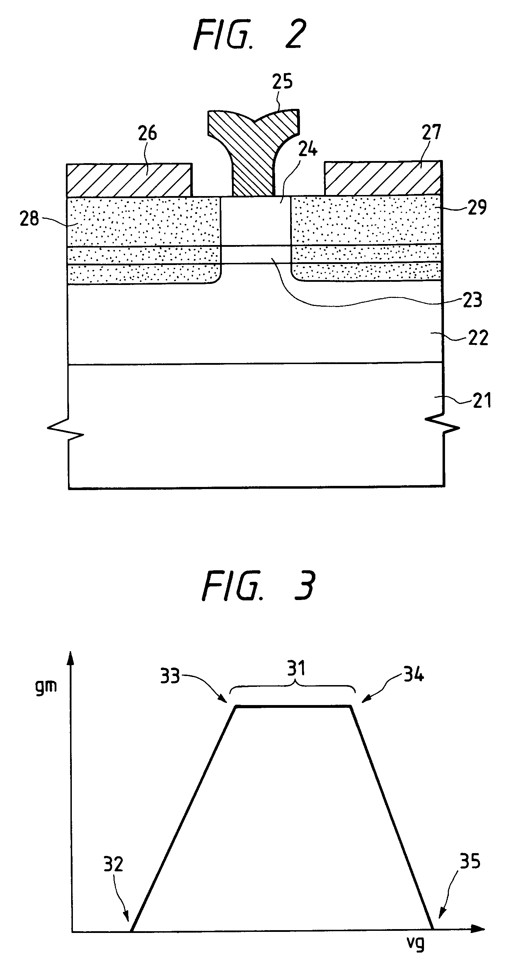

Fig. 2 is a sectional view showing a structure of the pulse-doped GaAs MESFET 1. An impurity-undoped $p^-$-GaAs buffer layer 22, a Si-pulse-doped GaAs layer 23 as an active layer and an impurity-undoped $n^+$-GaAs cap layer 24 are sequentially formed on a semi-insulating GaAs substrate 21 by epitaxial growth. In the source and drain regions, $n^+$ ion implantation regions 28, 29 are formed from the surface to the upper portion of the buffer layer 22. A gate electrode 25, that forms a Schottky junction with the cap layer 24, is formed on the part of the cap layer 24 that is interposed between the source and drain regions. A source electrode 26 and a drain electrode 27 are respectively formed on the source region and drain region so as to form an ohmic contact with the cap layer 24. Examples of the thickness of the respective layers are as follows: buffer layer 22, 10,000 Å; pulse-doped layer 23, 100 Å; and cap layer 24, 300 Å. An example of the impurity concentration of the pulse-doped layer 23 is 4.0 $\times$ $10^{18}$ cm$^{-3}$. The epitaxial growth is performed according to the OMVPE (organometallic vapor phase epitaxy) method. More specifically, the vapor phase growth is performed using a Cr-doped GaAs substrate under a pressure of 60 Torr and a temperature of 650$^\circ$C while TMG (trimethyl gallium) and AsH$_3$, and SiH$_6$ are introduced as source gases and a dopant gas, respectively. The V/III ratio of the source gas introduction is selected at 6 for the buffer layer 22, 40 for the pulse-doped layer 23, and 100 for the cap layer 24.

As shown in Fig. 1, an input circuit 2 and an output circuit 3 are respectively connected to the gate and the drain of the pulse-doped MESFET 1 thus formed. The input circuit 2 is designed so as to provide a function as an isolation filter for isolating an input high frequency signal (RF signal) from a terminal 5 and a local oscillation signal (LO signal) from a terminal 4 so that they do not interfere with each other. Further, the input circuit 2 is designed so as to provide the input impedance matching and the attenuation of an image frequency component. A terminal 6 is an input terminal of a DC bias voltage to be applied to the gate of the pulse-doped MESFET 1. The output circuit 3 includes a local oscillation signal short-circuiting circuit for preventing the local oscillation signal from leaking to an output terminal 7, and a low-pass filter for transmitting only an intermediate frequency signal (IF signal) as an output signal.

As in the case of the conventional FET mixer circuits, the mixer circuit of the present embodiment performs the frequency conversion by utilizing the nonlinearity of the transconductance. Therefore, the mixer circuit of the embodiment is required to operate at a gate bias point providing a nonlinear relationship between the transconductance $g_m$ and the gate voltage $v_g$. Further, among the gate bias points satisfying this condition, a point at which the input impedance does not vary largely with respect to the gate voltage variation caused by the large-amplitude local oscillation signal is selected as the final gate bias point.

Fig. 3 shows a relationship between the gate voltage $v_g$ and the transconductance $g_m$ of the pulse-doped GaAs MESFET 1. The vicinity of each of the four points indicated by reference numerals 32-35 can be the gate bias point at which the transconductance $g_m$ is nonlinear with respect to the gate voltage $v_g$. A large conversion efficiency can be obtained in the vicinity of these points 32-35. On the other hand, a point on a flat portion 31 can be selected as the gate bias point at which the input impedance does not vary largely with respect to the gate voltage variation.

The flat portion 31 of Fig. 3, in which the transconductance $g_m$ does not vary with respect to the gate voltage $v_g$, is specific to the pulse-doped GaAs MESFET, and is not obtained by the conventional devices. The invariability of the transconductance $g_m$ means that the variation of the input capacitance, i.e., gate-source capacitance $C_{gs}$ is small. Further, the input impedance of the FET largely depends on the gate-source capacitance $C_{gs}$. Therefore, as long as the gate voltage $v_g$ varies within the flat portion 31, no large variation occurs in the input impedance. The input impedance $Z_{in}$ is approximated as:

$$Z_{in} = R_g + 1/j\omega C_{gs} + R_{in} + R_s$$

where $R_g$ is a gate resistance, $R_{in}$ is a channel resistance and $R_s$ is a source resistance. This equation indicates that the input impedance largely depends on the gate-source capacitance $C_{gs}$.

From the above consideration, it is understood that the vicinity of each of the points 33 and 34 can be the gate bias point which satisfies the two conditions: nonlinearity of the transconductance $g_m$ and stability of the input impedance with respect to the temporal variation of the gate voltage $v_g$. Further considering the factor of small power consumption, the point 33 is finally selected as the desired gate bias point. That is, the vicinity of the transition point from the portion in which the transconductance $g_m$ increases with the gate voltage $v_g$ to the portion in which the former does not vary with the latter should be the desired gate bias point.

As described above, according to the mixer circuit of the invention, the pulse-doped GaAs MESFET is employed as the active device, and its gate bias point is set in the vicinity of the transition point from the portion in which the transconductance increases with the gate voltage to the portion in which the former does not vary with the latter. As a result, the mixer circuit can be realized which has a small input impedance variation and a sufficient conversion efficiency.

**Claims**

1. A mixer circuit comprising a pulse-doped GaAs MESFET as its active device, wherein a gate bias point of the pulse-doped GaAs MESFET is set at a vicinity of a transition point of a transconductance-gate voltage characteristic from a portion in which the transconductance increases with the gate voltage to a portion in which the transconductance does not vary substantially with the gate voltage.

2. The mixer circuit of claim 1, wherein the pulse-doped GaAs MESFET converts a higher frequency signal to a lower frequency signal.

3. The mixer circuit of claim 2, further comprising:

an input circuit connected to a gate of the pulse-doped GaAs MESFET, for receiving an input high frequency signal, a local oscillation signal and a gate bias voltage; and

an output circuit, connected to a drain of the pulse-doped GaAs MESFET, for outputting an intermediate frequency signal.

# FIG. 1

EP 0 551 857 A2

# FIG. 2

# FIG. 3